# EUROPEAN PATENT APPLICATION

(11) **EP 4 335 894 A1**
(43) Date of publication of application: **13.03.2024**
(21) Application number: 23811941.6
(22) Date of filing: 20.02.2023
(51) Int. Cl.: C08J 5/18, C08L 79/08, C08K 5/34, C08G 73/10

(54) **METHOD FOR MANUFACTURING POLYMER RESIN FILM, POLYMER RESIN FILM AND SUBSTRATE FOR DISPLAY DEVICE USING SAME, AND OPTICAL DEVICE**

(30) Priority: 24.05.2022 KR 20220063559
(71) Applicant: LG Chem, Ltd., Yeongdeungpo-gu Seoul 07336 (KR)
(72) Inventor: HAN, Seung Jin, Daejeon 34122 (KR); PARK, Jinyoung, Daejeon 34122 (KR); PARK, Chan Hyo, Daejeon 34122 (KR)
(74) Representative: Goddar, Heinz J.
(86) International application number: PCT/KR2023/002408
(87) International publication number: WO 2023/229154

(57) **Abstract**

The present invention relates to a method of preparing a polymer resin film capable of realizing excellent heat resistance and optical properties, a substrate for a display device using the polymer resin film, and an optical device.

## Description

### [FIELD OF THE INVENTION]

### Cross-reference to related application(s)

This application claims the benefit of priority to Korean Patent Application No. 10-2022-0063559, filed May 24, 2022, the entire disclosure of which is hereby incorporated by reference herein.

The present invention relates to a manufacturing method for a polymer resin film capable of realizing properties of excellent heat resistance and optical properties, a substrate for a display device using the polymer resin film, and an optical device.

### [BACKGROUND]

The display market is rapidly shifting toward flat panel displays (FPDs), which offer a large surface area, thinness, and lightweight. These flat panel displays include liquid crystal displays (LCD), organic light emitting displays (OLED), or electrophoretic displays (EPD).

Rigid type displays are manufactured using a glass substrate. Flexible type displays are manufactured using a plastic substrate as the base material.

However, as plastic substrates are applied to flexible displays, problems such as restoration artifacts appear, and plastic substrates have poor heat resistance, thermal conductivity, and electrical insulation compared to glass substrates.

Nevertheless, research is ongoing to replace glass substrates with plastic substrates, which have the advantages of being lightweight, flexible, and can be manufactured in a continuous process, for applications in mobile phones, notebook PCs, and televisions.

Polyimide resins are easy to synthesize, can be manufactured into thin films, and can be applied to high-temperature processes. In line with the trend toward lighter weight and more precision of electronic devices, polyimide resins are increasingly being used as integration materials in semiconductor materials. In particular, intensive research is being conducted to apply polyimide resins to flexible plastic display boards, which require lightweight and flexible properties.

### [DETAILED DESCRIPTION OF THE INVENTION]

### [PROBLEM TO BE SOLVED]

The present invention relates to a method of preparing for a polymer resin film capable of realizing properties of excellent heat resistance and optical properties.

Further, the present invention provides a polymer resin film prepared according to the above method of preparing a polymer resin film, a substrate for a display device using the polymer resin film, and an optical device.

### [MEANS TO SOVLE THE PROBLEM]

To solve the above problems, a method for producing a polymeric resin film is provided herein, comprising the steps of applying a polymeric resin composition comprising a polyimide-based resin and a nitrogen-containing polycyclic compound having 10 or more carbon atoms, to a substrate to form a coating; drying said coating; and curing said dried coating by heat treatment at an elevation rate of 4 °C/min or more.

Also provided herein is a polymeric resin film having a coefficient of thermal expansion of 23 ppm/°C or less at a temperature of 100°C or more and 400°C or less, and a transmittance of 80% or more for wavelengths from 380 nm to 780 nm.

Also provided herein is a substrate for a display device comprising the polymeric resin film.

Also provided herein is an optical device comprising the polymer resin film.

A method for preparing a polymer resin film, a substrate for a display device using the polymer resin film, and an optical device according to a specific embodiment of the present invention will be described in more detail below.

Unless otherwise expressly stated herein, technical terms are intended to refer only to specific embodiments and are not intended to limit the invention.

As used herein, singular forms include plural forms unless the context clearly indicates the contrary.

As used herein, the meaning of "including" is intended to specify certain characteristics, regions, integers, steps, actions, elements, and/or components and is not intended to exclude the existence or added value of other specific characteristics, regions, integers, steps, actions, elements, components, and/or groups.

Further, in this specification, terms including ordinal numbers, such as "first" and "second," are used for the purpose of distinguishing one component from another and are not limited by said ordinal numbers. For example, within the scope of the present invention, a first component may also be named a second component, and similarly, a second component may be named a first component.

As used herein, the term co-polymer includes both polymers and copolymers, wherein a polymer means a homopolymer comprising a single repeating unit and a copolymer means a complex polymer comprising two or more repeating units.

As used herein, examples of substituents are described below, but are not limited to.

As used herein, examples of substituents are described below, but are not limited thereto.

As used herein, the term "substitution" means the bonding of another functional group in place of a hydrogen atom in a compound, and the substituted position is not limited as long as the substituent is substitutable, and in the case of two or more substitutions, the two or more substituents may be identical or different from each other.

As used herein, the term "substituted or unsubstituted" includes deuterium; halogen; cyano; nitro; hydroxyl; carbonyl; ester; imide; amide; primary amino; carboxy; sulfonic acid; sulfonamide; phosphine oxide; alkoxy; aryloxy; alkylthio; arylthio; alkylsulfoxide; arylsulfoxide; silyl; boron; alkyl; cycloalkyl; alkenyl; aryl; aralkyl; aralkenyl; alkylaryl; alkoxysilylalkyl; aryl phosphine; or substituted or unsubstituted with 1 or more substituents selected from the group consisting of a heterocycle containing 1 or more of N, O, and S atoms, or substituted or unsubstituted with 2 or more of the above substituents which are linked. For example, a "substituent having 2 or more substituents connected" may be a biphenyl group, i.e., a biphenyl group may be an aryl group, or may be construed as a substituent having 2 phenyl groups connected.

As used herein, 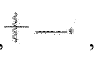 or means a bond that connects to another substituent, and a direct bond means that no separate atom is present at the portion denoted by L .

In the present invention, aromatic is a characteristic that satisfies the Huckels Rule, wherein an aromatic can be defined as satisfying all of the following three conditions according to the Huckels Rule.
1) There must be 4n+2 electrons that are fully conjugated by empty p-orbitals, unsaturated bonds, lone pairs, etc.
2) The 4n+2 electrons must form a planar isomer, which is a ring structure.
3) All atoms in the ring must be able to participate in the conjugation.

As used herein, a multivalent functional group is a residue in which a plurality of hydrogen atoms is removed from any compound, for example, a divalent functional group, a trivalent functional group, or a tetravalent functional group. In one example, a tetravalent functional group derived from cyclobutane refers to a residue with four hydrogen atoms removed that is bonded to cyclobutane.

As used herein, an aryl group is a monovalent functional group derived from arene, preferably but not exclusively having 6 to 20 carbon atoms, and may be a monocyclic aryl group or a polycyclic aryl group. The monocyclic aryl group may be, but is not limited to, a phenyl, biphenyl, or terphenyl group. Polycyclic aryl groups may include, but are not limited to, naphthyl, anthracenyl, phenanthryl, pyrenyl, perylenyl, chrysenyl, fluorenyl, and the like. The aryl groups may be substituted or unsubstituted, and if substituted, examples of substituents are as described above.

For the purposes of this specification, a direct or single bond means that no atoms or groups of atoms are present at that location and are connected by a bond. Specifically, it means that no separate atoms are present in the portion of the formula represented by L₁ and L₂.

As used herein, the weight average molecular weight refers to the weight average molecular weight of the polystyrene equivalent determined by the GPC method. In the process of determining the weight average molecular weight of polystyrene equivalent as determined by the GPC method, analytical devices and detectors such as differential refractive index detectors and analytical columns known in the art can be used, and conventional temperature conditions, solvents, and flow rates can be applied. As a specific example of the above measurement conditions, using a Waters PL-GPC220 instrument with a Polymer Laboratories PLgel MIX-B 300 mm long column, the evaluation temperature is 160 °C, 1,2,4-trichlorobenzene is used as the solvent, the flow rate is 1 mL/min, the sample is prepared at a concentration of 10 mg/10 mL and supplied in a volume of 200 µL, and the value of Mw is obtained using a black curve formed using a polystyrene standard. Nine polystyrene standards with molecular weights of 2,000 / 10,000 / 30,000 / 70,000 / 200,000 / 700,000 / 2,000,000 / 4,000,000 / 10,000,000 were used.

Hereinafter, the present invention will be described in more detail.

According to one embodiment of the invention, there is provided a method of manufacturing a polymeric resin film comprising: applying a polymeric resin composition comprising a polyimide-based resin and a nitrogen-containing polycyclic compound having 10 or more carbon atoms to a substrate to form a coating; drying the coating; and curing the dried coating by heat treatment at an elevated temperature rate of at least 4 °C/min.

The present inventors have confirmed through experiments and perfected the invention that by including a nitrogen-containing polycyclic compound having 10 or more carbon atoms as in the preparation method of the polymeric resin film of the first embodiment above, the nitrogen-containing polycyclic compound having 10 or more carbon atoms acts as a catalyst to promote the imidation of the polyimide-based resin, so that the polymer alignment and water removal of the polyimide-based resin in the polymeric resin composition before the solvent is volatilized can effectively occur. This will minimize the phenomenon of film lifting of the polymeric resin film in the final manufactured optical device.

Furthermore, the activity of the nitrogen-containing polycyclic compounds having 10 or more carbon atoms can be optimized by undergoing a curing process that involves heat treatment at an elevated rate of 4 °C/min or more. Experiments have confirmed that the polymer resin film finally prepared does not have the phenomenon of fluttering on the inorganic film deposition substrate, the optical properties such as yellow index and transmittance do not change significantly after the high temperature process above 430 °C, the morphology of individual layers or the morphology of the laminated structure does not change significantly. It was also confirmed that the change of physical properties is insignificant.

Specifically, according to one embodiment of the invention, there is provided a method of preparing a polymeric resin film, comprising: applying to a substrate to form a coating a polymeric resin composition comprising a polyimide-based resin and a nitrogen-containing polycyclic compound having 10 or more carbon atoms (Step 1); drying the coating (Step 2); and curing said dried coating by heat treatment at an elevated temperature rate of at least 4 °C/min (Step 3).

In Step 1, the polymeric resin composition comprising a polyimide-based resin and a nitrogen-containing polycyclic compound having 10 or more carbon atoms is applied to the substrate to form a coating. The method of applying the polymeric resin composition comprising the polyimide-based resin and the nitrogen-containing polycyclic compound having 10 or more carbon atoms to the substrate is not particularly limited, and may include, for example, screen printing, offset printing, flexographic printing, inkjet printing, and the like.

The polymeric resin composition comprising the polyimide-based resin and a nitrogen-containing polycyclic compound having 10 or more carbon atoms may be dissolved or dispersed in an organic solvent. If polyimide resin is synthesized in an organic solvent, for example, the solution may be the reaction solution itself or a dilution of the reaction solution with another solvent. Alternatively, if the polyimide resin is obtained as powder form, it may be dissolved in an organic solvent to form a solution.

The polymeric resin composition comprising the polyimide-based resin and the nitrogen-containing polycyclic compound having 10 or more carbon atoms may include solids in an amount that allows the composition to have a suitable viscosity in consideration of processability, such as applicability during the film-forming process. For example, the content of the composition can be adjusted so that the total resin content is at least 5 wt% but 25 wt% or less, or at least 5 wt% but 20 wt% or less, or at least 5 wt% but 15 wt% or less.

In addition, the polymeric resin composition comprising the polyimide-based resin and a nitrogen-containing polycyclic compound having 10 or more carbon atoms may further comprise other components in addition to the organic solvent. By way of non-limiting example, the resin composition comprising the polyimide resin may further include compounds that, when applied, may improve film thickness uniformity or surface smoothness, improve adhesion to a substrate, change dielectric constant or conductivity, or increase density. Examples of such compounds include surfactants, silane-based compounds, dielectric or crosslinking compounds, and the like.

More specifically, in the method of making the polymeric resin film of the above embodiments, the polymeric resin composition may include a nitrogen-containing polycyclic compound having 10 or more carbon atoms. The nitrogen-containing polycyclic compound having 10 or more carbon atoms may be included in the polymeric resin composition to act as a catalyst to promote imidation of the polyimide-based resin, such that polymer alignment and water removal of the polyimide-based resin in the polymeric resin composition prior to volatilization of the solvent can effectively occur. This will minimize film lifting of the polymeric resin film in the final manufactured optical device.

Further, the polymeric resin composition may comprise 0.001 wt% or less, 0.0001 wt% or less, 0.00001 wt% or less, of a nitrogen-containing polycyclic compound having 9 or less carbon atoms, based on the total weight of the polymeric resin composition.

That the polymeric resin composition comprises 0.001 wt% or less of a nitrogen-containing polycyclic compound having 9 or less carbon atoms may mean that said polymeric resin composition does not comprise a nitrogen-containing polycyclic compound having 9 or less carbon atoms.

Nitrogen-containing polycyclic compounds with 9 or less carbon atoms, such as quinoline and isoquinoline, are designated as hazardous chemicals in the National Chemicals Information System (NCIS). By adding nitrogen-containing polycyclic compounds with 10 or more carbon atoms, it was confirmed that excellent polymer resin films without fluttering or lifting phenomenon can be manufactured.

The types of nitrogen-containing polycyclic compounds having 10 or more carbon atoms are not substantially limited, but may include, for example, nitrogen-containing heterocyclic compounds having 10 or more carbon atoms. As used herein, a heterocyclic compound means a cyclic compound comprising at least one of the heteroatoms O, N, Si, and S.

More specifically, said nitrogen-containing polycyclic compounds having 10 or more carbon atoms can include nitrogen-containing heterocyclic aromatic compounds having 10 or more carbon atoms. As used herein, a heterocyclic aromatic compound means a cyclic aromatic compound comprising at least one of the heteroatoms O, N, Si, and S. Examples of heterocyclic aromatic compounds include thiophenes, furans, pyrroles, imidazoles, thiazoles, oxazoles, oxadiazoles, triazoles, pyridyl groups, bipyridines, pyrimidines, triazines, acridine pyridazines, pyrazines, quinolines, quinazolines, quinoxalines, phthalazines, pyridopyrimidines, pyridopyrazines, pyrazino pyrazine, isoquinoline, indole, carbazole, benzooxazole, benzoimidazole, benzothiazole, benzocarbazole, benzothiophene, dibenzothiophene, benzofuranyl group, phenanthroline, isoxazole, thiadiazole, phenothiazine, and dibenzofuran, but are not limited to. The heterocyclic aromatic compounds may be substituted or unsubstituted.

The nitrogen-containing heterocyclic aromatic compounds having 10 or more carbon atoms may include, for example, 4-methylquinoline (Lepidine).

The nitrogen-containing polycyclic compounds having 10 or more carbon atoms may be included in an amount of 0.1 wt% to 10 wt% by based on the total polymeric resin composition.

If the nitrogen-containing polycyclic compound having 10 or more carbon atoms is included in less than 1 wt% based on the total polymer resin composition, technical problems such as clogging in the curing process may occur due to insufficient inclusion of said nitrogen-containing polycyclic compound having 10 or more carbon atoms, If said nitrogen-containing polycyclic compounds having 10 or more carbon atoms are included in an amount greater than 10 wt% based on the total weight of polymer resin composition, this may lead to deterioration of the heat resistance and optical properties of the polymer.

Furthermore, the polymeric resin composition may comprise at least 0.1 parts by weight but 20 parts by weight or less, at least 1 part by weight and but 20 parts by weight or less, at least 5 parts by weight and but 20 parts by weight or less, at least 5 parts by weight but 15 parts by weight or less, of a nitrogen-containing polycyclic compound having 10 or more carbon atoms based on 100 parts by weight of the polyimide-based resin solids.

If the nitrogen-containing polycyclic compounds having 10 or more carbon atoms are included at less than 0.1 parts by weight based on 100 parts by weight of polyimide-based resin solids, technical problems such as film lifting in inorganic films may occur due to insufficient inclusion of the above nitrogen-containing polycyclic compounds with a carbon number of 10 or more, whereas if they are included at more than 20 parts by weight, technical problems such as deterioration of the overall polymer properties may occur.

In one aspect, the polyimide-based resin includes both polyimide and its precursor polymers, polyamic acid and polyamic acid ester. In other words, the polyimide-based polymer may include at least one type selected from the group consisting of polyamic acid repeating units, polyamic acid ester repeating units, and polyimide repeating units. That is, the polyimide-based polymer may comprise a copolymer of one polyamic acid repeating unit, one polyamic acid ester repeating unit, one polyimide repeating unit, or a mixture of two or more of these repeating units.

The one or more repeating units selected from the group consisting of said polyamic acid repeating units, polyamic acid ester repeating units, and polyimide repeating units may form the main chain of said polyimide-based polymer.

The polyimide-based resin film may comprise a cure of the polyimide-based resin. The cure of the polyimide-based resin means a product obtained by a curing process of the polyimide-based resin.

Specifically, said polyimide-based resin film may comprise a polyimide resin comprising aromatic imide repeating units.

In a tetracarboxylic acid or anhydride thereof and a diamine compound utilized as a monomer in the synthesis of a polyimide-based resin, said aromatic imide repeating unit may be implemented such that the tetracarboxylic acid or anhydride thereof includes an aromatic group, the diamine compound includes an aromatic group, or both the tetracarboxylic acid or anhydride thereof and the diamine compound include an aromatic group.

More specifically, said polyimide-based resin film may comprise a polyimide resin comprising aromatic imide repeating units.

In a tetracarboxylic acid or anhydride thereof and a diamine compound utilized as a monomer in the synthesis of a polyimide-based resin, said aromatic imide repeating unit may be implemented such that the tetracarboxylic acid or anhydride thereof includes an aromatic group, the diamine compound includes an aromatic group, or both the tetracarboxylic acid or anhydride thereof and the diamine compound include an aromatic group.

In particular, said polyimide-based resins may comprise polyimide repeating units represented by the following Formula 1.

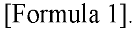

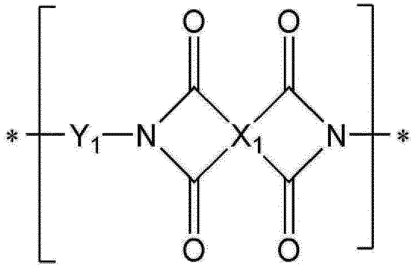

In Formula 1 above, X₁ is an aromatic tetravalent functional group and Y₁ is an aromatic divalent functional group having 6 to 10 carbon atoms.

Specifically, in Formula 1, Y₁ is an aromatic divalent functional group substituted with at least one fluorine functional group, which may be a functional group derived from a diamine compound used in the synthesis of polyimide-based resins.

As fluorine functional groups such as trifluoromethyl groups (-CF₃ ) with high electronegativity are substituted, improved transparency can be obtained by increasing the effect of inhibiting the formation of charge transfer complexes (CTC) of Pi-electrons present in the polyimide resin chains. In other words, packing within the polyimide structure or between chains can be reduced, and steric hindrance and electrical effects can weaken the electrical interaction between chromophores, resulting in high transparency in the visible light region.

Specifically, the aromatic divalent functional group substituted with at least one fluorine-based functional group of Y₁ may include the functional group represented by Formula 3-1 below.

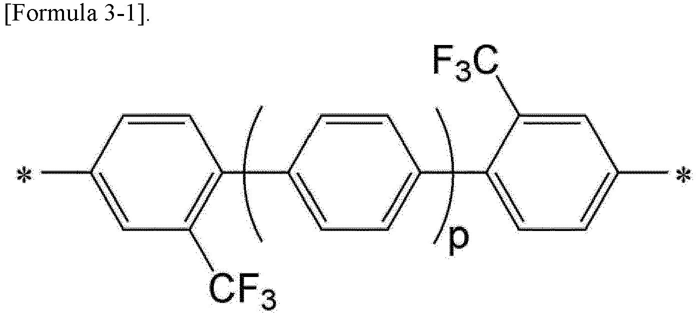

In Formula 3-1 above,
P is an integer between 0 and 5, preferably between 0 and 2.

More specifically, the polyimide-based resin may be formed by the reaction of a terminal anhydride group (-OC-O-CO-) of a tetracarboxylic acid dihydrate with a terminal amino group (-NH₂ ) of an aromatic diamine substituted with at least one fluorine functional group, wherein a bond is formed between a nitrogen atom of the amino group and a carbon atom of the anhydride group.

The polyimide-based resin can be prepared by reacting two or more different diamine compounds with a tetracarboxylic acid anhydride compound, and the two diamine compounds can be added simultaneously to synthesize a random copolymer, or added sequentially to synthesize a block copolymer.

In Formula 1, X₁ is a functional group derived from a tetracarboxylic acid anhydride compound used in the synthesis of polyimide-based resins.

Specifically, X₁ may be a quaternary functional group represented by Formula 5 below.

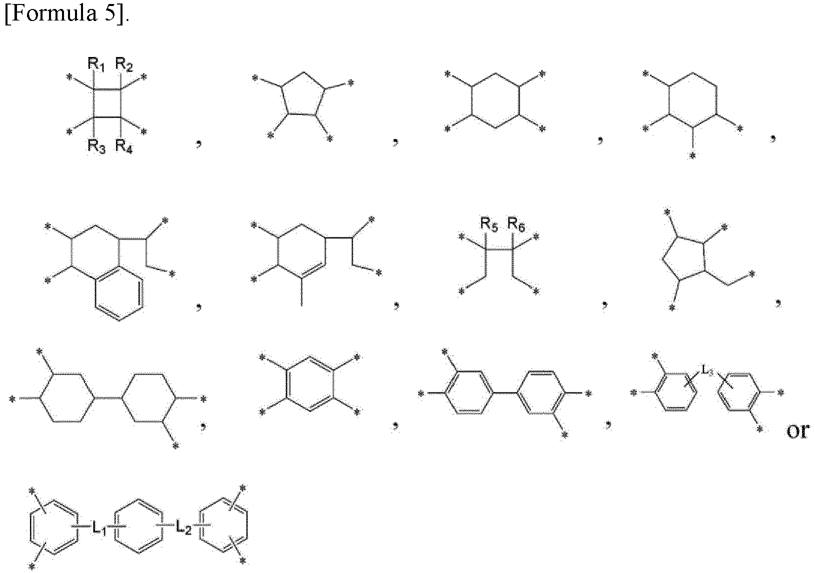

In Formula 5 above, R₁ to R₆ are each independently hydrogen or an alkyl group having 0 to 6 carbon atoms, L₁ and L₂ are the same or different from each other, and each independently one of -COO-, or -OCO-, and L₃ is selected from the group consisting of -O-, -CO-, -COO-, -S-, -SO-, -SO₂ -, -CR R₇₈ -, -(CH )₂ₜ -, -O(CH )₂ₜ O-, - COO(CH )₂ₜ OCO-, -CONH-, phenylene, and any combination thereof, wherein R₇ and R₈ are each independently selected from hydrogen, an alkyl group having 1 to 10 carbon atoms, or a haloalkyl group having 1 to 10 carbon atoms, and t is an integer from 1 to 10.

The polyimide-based resin can be prepared by reacting two or more different tetracarboxylic acid anhydride compounds with a diamine compound, and the two tetracarboxylic acid anhydride compounds can be added simultaneously to synthesize a random copolymer, or added sequentially to synthesize a block copolymer.

More specifically, said X₁ may comprise one or more tetravalent functional groups selected from the group consisting of the tetravalent functional groups represented by Formula 2-1 to Formula 2-4 below.

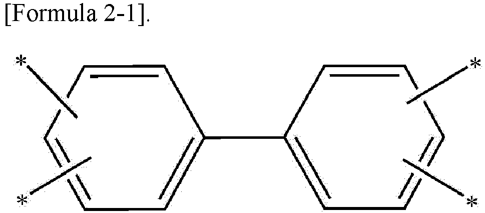

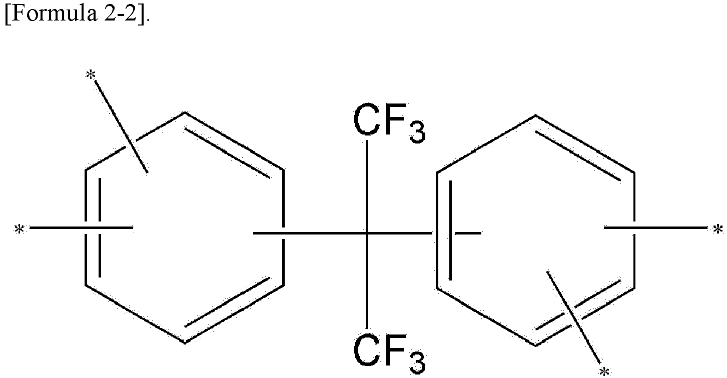

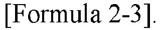

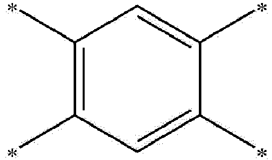

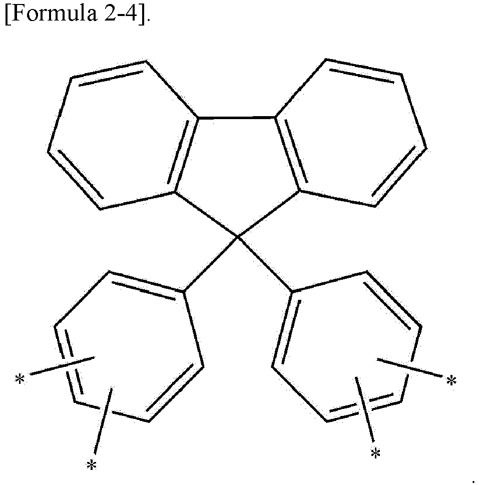

Specific examples of said aromatic tetracarboxylic acid dihydride include 3,3',4,4'-biphenyltetracarboxylic dianhydride (3,3',4,4'-Biphenyltetracarboxylic dianhydride, BPDA), 9,9'-bis(3,4-dicarboxyphenyl)fluorene dihydride (9,9'-bis(3,4-dicarboxyphenyl)fluorene dianhydride, BPAF), 4,4'-(hexafluoroisopropylidene)diphthalic anhydride, 6FDA, and Pyromellitic Dianhydride, PMDA.

The weight average molecular weight (as measured by GPC) of said polyimide-based resin is not intended to be limiting, but may be, for example, 1000 g/mol or more but 200000 g/mol or less, or 10000 g/mol or more but 200000 g/mol or less.

The polyimide-based resin according to the present invention can exhibit excellent colorless and transparent properties while maintaining properties such as heat resistance and mechanical strength due to its rigid structure. It can also be used in various fields such as substrates for devices, cover substrates for displays, optical films, integrated circuit (IC) packages, adhesive films, multilayer flexible printed circuits (FRCs), tapes, touch panels, and protective films for optical disks, and is particularly suitable for cover substrates for displays.

In Step 2, the coating formed by applying said polyimide-based resin and a nitrogen-containing polycyclic compound having 10 or more carbon atoms to the substrate is dried.

The drying step of the coating may be carried out by heating means such as a hot plate, a hot air circulation furnace, an infrared furnace, and the like, and may be carried out at a temperature of at least 50 °C but 150 °C or less, or 50 °C or more but 100 °C or less.

In Step 3, the dried coating is cured by heat treatment. The heat treatment may be performed by heating means such as a hot plate, a hot air circulation furnace, an infrared furnace, and the like.

Specifically, Step 3 may be heat treated at an elevated temperature rate of at least 4°C/min, at least 4°C/min but 10°C/min or less, at least 4°C/min but 7°C/min or less.

As the above Step 3 is heat treated at an elevated temperature rate of 4 °C/min or more, the promotion of imidation of the nitrogen-containing polycyclic compounds having 10 or more carbon atoms is accelerated, resulting in rapid imidation of the polyimide-based resin, thereby enabling excellent heat resistance properties to be realized even for high-temperature processes of 400 °C or more, while optical properties such as transmittance are not sacrificed due to increased polymer orientation.

If the elevated temperature rate is less than 4 °C/min in Step 3 above, the nitrogen-containing polycyclic chemicals having 10 or more carbon atoms are volatilized in the low temperature zone before the role of the imide accelerator, and are not effective in improving the permeability and heat resistance properties.

In one aspect, the step of curing said dried coating by heat treating at an elevated temperature rate of 4°C/min or more may comprise the step of curing said dried coating by heat treating at an elevated temperature rate of 4°C/min or more from an initial temperature of not less than 50°C and 100°C or less to a final temperature of at least 400°C but 500°C or less.

According to another embodiment of the invention, there may be provided a polymeric resin film having a coefficient of thermal expansion of 23 ppm/°C or less at a temperature of at least 100°C but 400°C or less, and a transmittance of at least 80% for wavelengths from 380 nm to 780 nm.

The polymer resin film may be prepared according to the method for preparing the polymer resin film described above.

That is, said polymeric resin film may comprise a polyimide-based resin and a nitrogen-containing polycyclic compound having 10 or more carbon atoms.

The above description of polyimide-based resins and nitrogen-containing polycyclic compounds having 10 or more carbon atoms includes all of the foregoing.

In one aspect, the polymeric resin film may comprise 0.001 wt% or less, 0.0001 wt% or less, 0.00001 wt% or less, of a nitrogen-containing polycyclic compound having 9 or less carbon atoms based on the total weight of the polymeric resin film.

That the polymeric resin film comprises 0.001 wt% or less of a nitrogen-containing polycyclic compound having 9 or less carbon atoms may mean that said polymeric resin film does not comprise a nitrogen-containing polycyclic compound having 9 or less carbon atoms.

Nitrogen-containing polycyclic compounds with 9 or less carbon atoms, such as quinoline and isoquinoline, which have been widely used in the past, are designated as hazardous chemicals by the National Chemicals Information SYstem (NCIS), and therefore, excellent polymer resin films without haze phenomenon can be prepared by adding nitrogen-containing polycyclic compounds having 10 or more carbon atoms to replace them.

The polymer resin film may have a coefficient of thermal expansion of 23 ppm/°C or less at a temperature of 100 °C or more and 400 °C or less, and a transmittance of 80% or more for a wavelength of 380 nm to 780 nm according to the method of preparing the polymer resin film described above.

The thickness of the polyimide-based resin film is not substantially limited, but is freely adjustable, for example, within a range of 0.01 µm or more and 1000 µm or less. When the thickness of the polyimide-based resin film increases or decreases by a certain value, the physical properties measured in the polyimide-based resin film may also change accordingly.

Further, the polymeric resin film of the above embodiments may have a transmittance, for wavelengths from 380 nm to 780 nm, of 80% or more, 90% or less, 80% or more and 90% or less.

The method of measuring said transmittance is not substantially limited, but may be measured, for example, using UV-vis spectroscopy. More specifically, the transmittance may be measured for light with a wavelength of 450 nm using a UV-vis spectroscopy device.

Since the polymer resin film of the above embodiment has a transmittance of 80% or more for wavelengths from 380 nm to 780 nm, excellent optical properties can be realized.

In another embodiment, a substrate for a display device comprising a polymeric resin film is provided. The polymeric resin film may include all of those described above.

A display device including the substrate may include, but is not limited to, a liquid crystal display device (LCD), an organic light emitting diode (OLED), a flexible display, or a rollable or foldable display.

The display device may have a variety of structures depending on the application and specific form, and may include, for example, a cover plastic window, a touch panel, a polarizer, a barrier film, a light-emitting element (such as an OLED element), a transparent substrate, and the like.

The polymeric resin films of other embodiments described above can be used in these various display devices for a variety of applications, such as as a substrate, an outer protective film, or a cover window, and more specifically as a substrate.

For example, the substrate for the display device may have a structure in which an element protection layer, a transparent electrode layer, a silicon oxide layer, a polyimide-based resin film, a silicon oxide layer, and a hard coating layer are sequentially laminated.

The transparent polyimide substrate may comprise a silicon oxide layer formed between the transparent polyimide-based resin film and the curing layer, which may further improve solvent resistance, water permeability, and optical properties, wherein the silicon oxide layer is produced by curing a polysilazane.

Specifically, said silicon oxide layer may be formed by coating and drying a solution comprising polysilazane prior to the step of forming a coating layer on at least one surface of the transparent polyimide-based resin film, and then curing said coated polysilazane.

By including the device protection layer described above, the substrate for a display device according to the present invention can provide a transparent polyimide cover substrate having excellent bending properties and impact resistance, while securing solvent resistance, optical properties, moisture permeability, and scratch resistance.

According to another embodiment of the invention, there may be provided an optical device comprising the polymeric resin film of said other embodiment. Said polymeric resin film may include all of those described above in the above embodiment.

The optical device may include any device utilizing the property of being realized by light, for example, a display device. Specific examples of such display devices include, but are not limited to, liquid crystal display devices (LCDs), organic light emitting diodes (OLEDs), flexible displays, or rollable or foldable displays.

The optical device may have a variety of structures depending on the application and specific form, and may include, for example, a cover plastic window, a touch panel, a polarizer, a barrier film, a light-emitting element (such as an OLED element), a transparent substrate, and the like.

The polymeric resin films of other embodiments described above can be used in these various optical devices for a variety of applications, including as substrates, outer protective films, or cover windows, and more specifically as substrates.

### [Effects of Invention]

According to the present invention, a polymer resin composition capable of realizing properties of excellent heat resistance and optical properties, a method of preparing a polymer resin film, a substrate for a display device using the polymer resin film, and an optical device may be provided.

The invention is described in more detail in the following embodiments. However, the following embodiments are only illustrative of the invention, and the content of the invention is not limited by the following embodiments.

### <Examples and Comparative Examples: Preparation of polyimide compositions and polyimide films>.

### Example 1

### (1) Preparation of polyimide compositions

After adding 155 g of N,N-diethylacetamide (DEAc, N,N-diethylacetamide) in a stirrer with a nitrogen stream, 2,2'-bis(trifluoromethyl)benzidine (TFMB, 2,2'-bis(trifluoromethyl)benzidine) 27.62 g (0.09 mol) was added at the same temperature to dissolve while the temperature of the reactor was maintained at 25 °C. To the above solution, 3,3',4,4'-biphenyltetracarboxylic dianhydride (BPDA) 5.07 g (0.02 mol), 9,9'-bis(3,4-dicarboxyphenyl)fluorene dianhydride (BPAF) 3.95 g (0.02 mol) and Pyromellitic Dianhydride (PMDA) 13.14 g (0.06 mol) were added at the same temperature and stirred for 24 hours. At this time, 15 g of polyimide solids were obtained out of a total of 180 g of the prepared polyimide precursor composition.

1.35 g, 5 wt% based on the total solids content of Lepidine (4-methylquinoline) was then added and stirred to prepare a polyimide precursor composition.

### (2) Manufacturing of polyimide films

The polyimide precursor composition was spin coated on the glass substrate. The glass substrate to which the polyimide precursor composition was applied was heat treated from 80 °C to 460 °C at an elevated temperature rate of 4 °C/min for 200 min, and a curing process was performed to prepare a polyimide film having a thickness of 10 µm (with an error of ±1 µm) on the glass substrate.

### Example 2

The polyimide precursor composition and polyimide film were prepared by the same method as in Example 1 above, except that 2.7 g, 10 wt% based on the total solids content of Lepidine (4-methylquinoline) was added.

### Example 3

The polyimide precursor composition and polyimide film were prepared by the same method as in Example 1 above, except that 8.1 g, 30 wt% based on the total solids content of Lepidine (4-methylquinoline) was added.

### Example 4

In the preparation of the polyimide film, the polyimide precursor composition and the polyimide film were prepared by the same method as in Example 1 above, except that the glass substrate to which the polyimide precursor composition was applied was heat treated from 80 °C to 460 °C at an elevated temperature rate of 7 °C/min and the curing process was carried out for 120 minutes.

### Example 5

The polyimide precursor composition and the polyimide film were prepared by the same method as in Example 1 above, except that 2.7 g, 10 wt% based on the total solids content of Lepidine (4-methylquinoline) was added, and the glass substrate on which the polyimide precursor composition was applied in the preparation of the polyimide film was heat treated from 80 °C to 460 °C at a ramping rate of 7 °C/min and the curing process was carried out for 120 min.

### Example 6

The polyimide precursor composition and the polyimide film were prepared by the same method as in Example 1 above, except that 8.1 g, 30 wt% based on the total solids content of Lepidine (4-methylquinoline) was added, and the glass substrate on which the polyimide precursor composition was applied in the preparation of the polyimide film was heat treated from 80 °C to 460 °C at an elevated temperature rate of 5 °C/min and the curing process was carried out for 120 min.

### Comparative Example 1

The polyimide precursor composition and polyimide film were prepared by the same method as in Example 1 above, except that Lepidine (4-methylquinoline) was not added.

### Comparative Example 2

The polyimide precursor composition and polyimide film were prepared by the same method as in Example 1 above, except that, without adding Lepidine (4-methylquinoline), the glass substrate to which the polyimide precursor composition was applied in the preparation of the polyimide film was heat treated from 80 °C to 460 °C at an elevated temperature rate of 2.5 °C/min from 80 °C to 460 °C, and the curing process was carried out for 180 minutes.

### Comparative Example 3

The polyimide precursor composition and the polyimide film were prepared by the same method as in Example 1 above, except that, without adding Lepidine (4-methylquinoline), the glass substrate to which the polyimide precursor composition was applied in the preparation of the polyimide film was heat treated from 80 °C to 460 °C at an elevated heat temperature rate of 7 °C/min and the curing process was carried out for 120 minutes.

### Comparative Example 4

The polyimide precursor composition and polyimide film were prepared by the same method as in Example 1 above, except that 1.35 g of 5 wt% Quinoline based on the total solid content was added instead of Lepidine (4-methylquinoline)

### Comparative Example 5

The polyimide precursor composition and polyimide film were prepared by the same method as in Example 1 above, except that 1.35 g of 5 wt% Isoquinoline based on the total solid content was added instead of Lepidine (4-methylquinoline)

### <Experimental Examples: Measurement of Properties of Polyimide Precursor Compositions and Polyimide Films Obtained in Example and Comparative Examples

The properties of the polyimide precursor compositions and polyimide films obtained in the above examples and comparative examples were measured by the following methods, and the results are shown in Tables 1 to 3.

### 1. CTE

Using a TMA (TA's Q400), the temperature was raised to 180°C at a rate of 5°C/min, held at that temperature for 10 minutes, cooled to 50°C at a rate of 5°C/min, and then raised to 400°C at a rate of 5°C/min to measure the CTE during the elevation process.

### 2. Transmittance

Transmittance (T) to light at a wavelength of 450 nm was measured using a UV-vis spectroscopy (Agillent, UV 8453) device.

**[Table 1]**

| Experimental Results of Examples 1-3 | | | |
|---|---|---|---|
| | Example 1 | Example 2 | Example 3 |
| Lepidine (wt%) | 5 | 10 | 30 |
| Solids Content (%) | 15 | 15 | 15 |
| CTE (ppm/°C) | 23 | 23 | 20 |
| T (Transmittance) (%) @450 nm | 82 | 83 | 82 |

**[Table 2]**

| Experimental Results of Examples 4-6 | | | |
|---|---|---|---|
| | Example 4 | Example 5 | Example 6 |
| Lepidine (wt%) | 5 | 10 | 30 |
| Solids Content (%) | 15 | 15 | 15 |
| CTE (ppm/°C) | 11.5 | 4.6 | 6.0 |
| T (Transmittance) (%) @450 nm | 82 | 82 | 82 |

**[Table 3]**

| Measurement in Example 1-5 | | | | | |
|---|---|---|---|---|---|
| | Comparative Example 1 | Comparative Example 2 | Comparative Example 3 | Comparative Example 4 | Comparative Example 5 |
| Lepidine (wt%) | -. | -. | -. | -. | -. |
| Quinoline (wt%) | -. | -. | -. | 5 | -. |
| Isoquinoline (wt%) | -. | -. | -. | -. | 5 |
| Solid Content | 15 | 15 | 15 | 15 | 15 |
| (%) | | | | | |
| CTE (ppm/°C) | 25 | 15.1 | 12.9 | 34 | 24 |
| T (Transmittance) (%) @450 nm | 83 | 75 | 76 | 84 | 77 |

As shown in Tables 1 and 2 above, the polymer resin film of the embodiments exhibits a CTE of more than 6.0 ppm/°C and less than 23 ppm/°C, and a transmittance of more than 82%, which confirms that the polymer resin film has excellent heat resistance and optical properties.

On the other hand, for Comparative Examples 1 through 5, the CTE was greater than 24 ppm/°C, indicating poor heat resistance, or the transmittance was 77% or less, indicating poor optical properties, as shown in Table 3.

## Claims

1. A method of preparing a polymeric resin film, comprising:
applying to a substrate a polymeric resin composition comprising a polyimide resin and a nitrogen-containing polycyclic compound having 10 or more carbon atoms to form a coating;
drying the coating; and
curing the dried coating by heat treatment at an elevated temperature rate of at least 4 °C/min.

2. The method of preparing a polymeric resin film according to claim 1, wherein the step of curing the dried coating comprises the step of curing the dried coating by heat treating the dried coating from an initial temperature of from at least 50 °C to 100 °C or less to a final temperature of from at least 400 °C to 500 °C less at an elevation temperature rate of at least 4 °C/min.

3. The method of preparing a polymeric resin film according to claim 1, wherein the polymeric resin composition comprises 0.001 wt% or less of a nitrogen-containing polycyclic compound having 9 or less carbon atoms based on the total weight of the polymeric resin composition.

4. The method of preparing a polymeric resin film according to claim 1, wherein the nitrogen-containing polycyclic compound having 10 or more carbon atoms comprises a nitrogen-containing heterocyclic compound having 10 or more carbon atoms.

5. The method of preparing a polymeric resin film according to claim 1, wherein the nitrogen-containing polycyclic compound having 10 or more carbon atoms is included in the amount of 1 to 10 wt% based on the total weight of the polymeric resin composition.

6. The method of preparing a polymeric resin film according to claim 1, wherein the polymeric resin composition comprises 0.1 to 20 parts by weight of the nitrogen-containing polycyclic compound having 10 or more carbon atoms based on 100 parts by weight of a polyimide resin solids.

7. The method of preparing a polymeric resin film according to claim 1, wherein the polyimide resin includes a polyimide resin comprising an aromatic imide repeating unit.

8. The method of preparing a polymeric resin film according to claim 1, wherein the polyimide resin comprises a polyimide repeating unit represented by the following Formula 1: 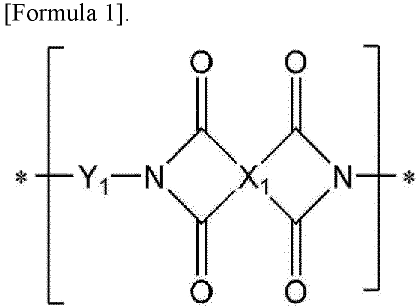 in the Formula 1,
X₁ is an aromatic tetravalent functional group, and
Y₁ is an aromatic divalent functional group having 6 to 10 carbon atoms.

9. The method of preparing a polymeric resin film according to claim 8, wherein X₁ comprises the tetravalent functional group represented by the following Formula 2:

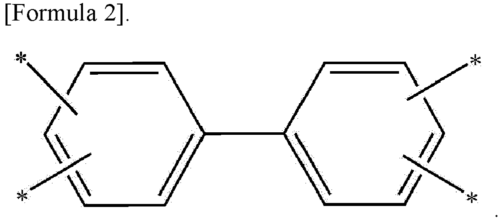

10. A polymer resin film having a coefficient of thermal expansion of 23 ppm/°C or less at temperatures between 100°C and 400°C, and a transmittance of at least 80% for wavelengths from 380 nm to 780 nm.

11. The polymeric resin film according to claim 10, wherein the polymeric resin film comprises a polyimide resin and a nitrogen-containing polycyclic compound having 10 or more carbon atoms.

12. The polymeric resin film according to claim 10, wherein the polymeric resin film comprises 0.001 wt% or less of a nitrogen-containing polycyclic compound having 9 or less carbon atoms based on the total weight of the polymeric resin film.

13. A substrate for a display device, comprising the polymeric resin film of claim 10.

14. An optical device, comprising the polymeric resin film of claim 10.
